# EUROPEAN PATENT APPLICATION

(11) **EP 2 393 304 A1**
(43) Date of publication of application: **07.12.2011**
(21) Application number: 10075237.7
(22) Date of filing: 01.06.2010
(51) Int. Cl.: H04Q 1/02, H05K 5/00, H05K 7/18

(54) **Profiled beam to build a light weight solid cable management cabinet**

(71) Applicant: Tyco Electronics Raychem BVBA, 3010 Kessel-Lo (BE)
(72) Inventor: Bleus, Heidi, 3600 Genk (BE); Vandoren, Ruth, 3390 Sint Joris Winge (BE); Thijs, Danny, 3520 Zonhoven (BE)
(74) Representative: Grünecker, Kinkeldey, Stockmair & Schwanhäusser

(57) **Abstract**

The invention relates to a profiled beam (3) for building a cable management cabinet (1), an assembly kit for building a cable management (1), comprising said profiled beam (3), a joining element (4) and a fastener (5) for affixing the joining element (4) to the profiled beam (3), as well as a cable management cabinet (1) composed of profiled beams (3), joining elements (4) that connect the profiled beams (3), and fasteners (5) that affix the joining elements (4) to the profiled beams (3). To provide a cable management cabinet that is light weight, but solid and composed of elements that can be quickly and easily assembled for the installation of the cable management cabinet the profiled beam (3) comprises at least one positioning groove (19), at least one fastening channel (26), and at least one fixation hole (21) forming an opening from the fastening channel (26) to the positioning groove (19) and facing a sidewall (38) of the positioning groove (19).

## Description

The invention relates to a profiled beam for building a cable management cabinet, an assembly kit for building a cable management, comprising said profiled beam, a joining element and a fastener for affixing the joining element to the profiled beam, as well as a cable management cabinet composed of profiled beams, joining elements that connect the profiled beams and fasteners that affix the joining elements to the profiled beams.

Telecommunications systems commonly include cables for interconnecting pieces of telecommunications equipment. Suppliers and users of structured connectivity communications systems in local area networks often have difficulty managing the cabling and patching points. Because of the large number of cables present at such patching points, cable management is crucial. Cable management involves efficiently routing cables to minimize the space occupied by such cables. Cable management also involves routing cables in an orderly manner so as to reduce the likelihood of "spaghetti", i.e., tangling of cables.

To route cables orderly, cable management cabinets are known. In the present application, a "cable management cabinet" refers to a generic rack used in an arbitrary telecommunication application. However, cable management cabinets are heavy structures that are either manufactured by wielding the frame elements or are labour-intensive systems that are difficult to assemble.

In light of the foregoing, an objective of the present invention is to provide a cable management cabinet system that is light weight, but solid and composed of elements that can be quickly and easily assembled for the installation of the cable management cabinet.

This problem is solved according to the present invention by a profiled beam comprising at least one positioning groove, at least one fastening channel, and at least one fixation hole forming an opening from the fastening channel to the positioning groove and facing a side wall of the positioning groove. The assembly kit of the present invention solves the problem by comprising such a profiled beam, a joining element comprising at least two through-holes, and a fastener for affixing the joining element to the profiled beam, when being positioned extending through a fixation hole of the beam and a through-hole of the joining element. With such a kit a cable management cabinet of the present invention can be quickly and easily assembled, that is composed of profiled beams according to the present invention, which may build the frame of the cabinet, joining elements comprising at least two through-holes that connect profiled beams, and fasteners that affix the joining elements to the profiled beams in the positioning grooves by extending through a fixation hole of a beam and through-hole of a joining element. By using such profiled beams, an open cabie management system is provided that can be assembled in an easy way by arranging the joining elements with at least one through-hole in the positioning groove of the profiled beams such that the through-hole is in alignment with a fixation hole. Thereafter, the joining element can be easily affixed to the profiled beam by inserting a fastener into the fastening beam and introducing said fastener such that it extends from the fastening channel through the fixation hole and the through-hole of the joining element. Thereby, the joining element is easily secured such that it can not move relative to the profiled beam. The cable management cabinet can be quickly installed because, except for the introduction of the fastener, no other fastening means are necessary. Assembling the cable management cabinet as an open system that is composed of profiled beams further does not require heavy structural elements, so that the cable management system of the present invention allows for a light weight structure that is yet solid because of the safe connection between the profiled beams using joining elements and fasteners as described above.

The solution according to the invention may be combined in any way with the following further advantageous embodiments, respectively, and further improved.

According to a first advantageous embodiment of the profiled beam, at least one of the positioning groove and the fastening channel runs substantially along the longitudinal direction of the beam. Thereby, the joining element or a cable management hardware and accessories that are to be attached to the profiled beams of the cable management cabinet can be affixed at an arbitrary position along the longitudinal direction of the beam. This allows for a great flexibility of the installation of the cable management cabinet system and of the attachment of cable management hardware, e.g. cable organizers, thereto.

The flexibility and the ease to add and remove cable management hardware and accessories can further be improved by an embodiment of the profiled beam, wherein a series of fixation holes are formed along the fastening channel. In this embodiment, it is not necessary to position the cable management hardware and accessory only at a small number of predefined positions along the longitudinal direction of the beam. Rather, the series of fixation holes initially formed along the fastening channel provide numerous predefined positions of attachment in a simple manner. Preferably, the fixation holes in the series are uniformly spaced apart from each other thereby allowing for a nearly arbitrary attachment of the cable management hardware and accessory to a profiled beam along its longitudinal direction.

In a further advantageous embodiment of the profiled beam, a depth direction of the fastening channel and a depth direction of the corresponding positioning groove are substantially perpendicular. By arranging the fastening channel and the positioning groove, with respect to their depth direction, perpendicular to each other, e.g. by providing the fastening channel and the corresponding positioning groove at substantially perpendicular surfaces of the profiled beam, the fastener may be introduced extending vertically through the positioning groove from one side of the positioning groove to the other side. Since the joining element or the cable management hardware and/or accessories are generally introduced in an introduction direction that corresponds to the depth direction of the positioning groove, this allows for the secure fixation of said joining element, cable management hardware and/or accessory against the introduction direction in the positioning groove.

A secure locking of joining plate, cable management hardware or accessory to be connected with a profiled beam can be further improved by at least one locking recess that is formed in the sidewall i.e. the sidewall of the positioning groove opposite to the fixation hole, and that is in alignment with a corresponding fixation hole. By providing the positioning groove with such locking- recess, it is possible to secure the fastener on both side walls of the positioning groove, namely in the fixation hole and in the locking recess.

In one embodiment, the locking recess may be a blind hole, in which the firstly introduced end of the fastener can rest in the final fixation position of the fastener, where it affixes the joining element in the positioning groove to the profiled beam. This allows for a secure interlocking of the firstly introduced end of the fastener in the positioning groove with respect to the longitudinal axis as well as the depth direction of the positioning groove.

In another embodiment, the locking recess may be formed as a locking groove that runs substantially parallel to the positioning groove and/or the fastening channel. Such a locking groove may be useful when providing the profiled beam with a series of fixation holes formed along the fastening channel, because then the locking groove may serve as the catch for each fastener introduced through any one of the fixation holes of the series.

in a further advantageous embodiment, the fastening channel may be an undercut channel. Such undercut channel allows for mounting the fastener within the fastening channel, e.g., when the fastener comprises an attachment part to be positioned in said undercut. Thus, the fastener may be secured against being removed from the fastening channel by being arranged behind the undercut on one hand and is, on the other hand, at the same time slideable along the longitudinal direction of the fastening channel because the undercut of the channel and the attachment part of the fastener form a guidance running along the fastening channel. An improved attachment and/or guidance of the fastening channel can be achieved by providing the fastening channel as a T-slot channel or a channel having an undercut on both sidewalls of the fastening channel. A T-slot channel allows for securing the fastener on both sidewalls of the fastening channel and moreover provides for a symmetrical guidance on both sides of the fastening channel thereby avoiding a tilting and jamming of the slideably mounted fastener in the channel.

In a further embodiment, one sidewall of the positioning groove may be pulvinated and the other sidewall may be dished. A positioning groove having such a design has a substantially curved cross-section which allows for a three-point support of the joining element and cable management hardware and accessory in the positioning groove. One support point is at the entrance of the positioning groove, a second support point is at the bottom of the positioning groove, and the third support point is at the crest of the curvature. Apart from a secure three-point support, this embodiment of the positioning groove allows for an indication that the joining element has been completely introduced into the positioning groove because, in case of an incomplete introduction in the insertion direction, the joining element would not be placed along the depth direction of the positioning groove but rather angled thereto. Furthermore, the insertion is improved because in case of a fastening channel having a pulvinated sidewall and a dished sidewall, the width of the channel could be broader than the thickness of the joining element or the cable management hardware and accessory, which reduces the friction upon insertion of such elements, while at the same time ensuring a safe support of said elements in the introduced state because of the three-point support structure. The embodiment having a pulvinated sidewall and a dished sidewall of the positioning groove may also encompass embodiments, wherein the sidewalls are not roundly curved, but rather constructions of three or more linear segments that are angled with respect to each other forming the curvature. The introduction of the joining element or the cable management hardware and accessories may be facilitated by providing the opening of the positioning groups slightly cone-shaped providing a guidance for introducing the respective side of the joining element into the positioning groove.

For an easy mounting and securing of the fastener in the fastening channel, in a further embodiment, the fastening channel may be a stopped/blind channel opening on one side of the profiled beam, or a through-channel extending completely through the profiled beam. Likewise, the positioning groove may be a stopped/blind groove or a through-groove for introducing cable management hardware and accessories along the longitudinal direction of the profiled beam such that said cable management hardware and accessories are slideable along the longitudinal direction of the profiled beam, but may not removed in the direction opposite to the depth direction of the positioning groove.

The profiled beam can be easily manufactured as an extrusion profile, e.g. the metal profile. In one embodiment, the profiled beam may be an aluminium extrusion profile providing for a solid, but light weight cable management cabinet system.

In a further embodiment, the profiled beam may be provided with two positioning grooves that are preferably arranged at opposite sides of the profiled beam. Profiled beam having two or more positioning grooves allows for an easy affixing of joining elements and/or cable management hardware and accessories at the preferred side of the profiled beam. For example, a profiled beam may have two positioning grooves at opposite sides, e.g. the two lateral side faces, of the profiled beam. Such beam allows for a flexible system for assembling a cable management cabinet.

The assembly of a cable management cabinet with profiled beams according to the present invention and the attachment of cable management hardware and accessories to such cabinet can be further improved by two fastening channels that are arranged at the same side of the profiled beam. Each fastening channel may be assigned to a different positioning groove. Thereby, a joining element and/or a cable management hardware and accessories may be affixed from the same side within each of the positioning grooves facilitating the installation and attachment.

In a further embodiment, the profiled beam may be symmetrically designed with respect to a plane of symmetry running along the longitudinal direction of the beam. Such design allows for a well balanced structure and improves stability of the profiled beam when being assembled.

The invention will be discussed hereafter in greater detail in an exemplary manner using advantageous embodiments and with reference to the drawings. The described embodiments are only possible configurations in which, however, the individual features as described above can be provided independently of one another or can be omitted.

The figures show the following:
- Figure 1A: a schematic, perspective view of a cable management cabinet in the assembled state;
- Figure 1 B:: the top view of the cable management cabinet system of Figure 1A;
- Figures 2A, 2B:: the assembling of the top and bottom corners of the cable management cabinet of Figure 1A and 1 B;
- Figures 3A, 3B:: the connection of a cross-beam in the cable management cabinet of Figure 1A;
- Figures 4A, 4B:: the frame of a cable management cabinet according to a second embodiment in the assembled state (Figure 4A) and a top view thereof (Figure 4B);
- Figures 5A, 5B:: corner connections of the cable management cabinet system of Figure 4A;
- Figures 6A, 6B:: a base corner connection including the feet connection of the cable management cabinet of Figure 4A;
- Figure 7:: the connection of the longitudinal girder of the cable management cabinet of Figure 4A;
- Figure 8:: a schematic perspective view of a profiled beam of the present application including cable management hardware to be attached thereto and a first embodiment of fasteners for affixing the cable management hardware to the profiled beam prior;
- Figure 9A, 9B:: the cable management hardware of Figure 8 attached to the profiled beam by the fastener in a schematic perspective (Figure 9A) and a cross sectional representation along the section line A-A of Figure 9A (Figure 9B);
- Figure 10A, 10B: a perspective schematic representation of the cable management hardware and the profiled beam of Figure 8 with a second embodiment of a fastener (Figure 10A) and a cross sectional representation along section line A-A thereof (Figure 10B);
- Figure 11:: the cable management hardware inserted in the position groove of the profiled beam of Figure 10 prior to affixing the cable management hardware in a perspective schematic representation (Figure 11A) and a cross-sectional view along section line A-A thereof (Figure 11 B);
- Figures 12A; 12B:: the cable management hardware and the profile beam of Figures 10 and 11 in the affixed state in a schematic perspective view (Figure 12A) and a cross-sectional representation along section line A-A thereof (Figure 12B);
- Figures 13A, 13B:: the top view (Figure 13A) and the bottom view (Figure 13B) in a schematic perspective representation of an adaptor clip for connecting cable management hardware to a profiled beam according to the present application;
- Figure 14:: the adaptor clip of Figures 13 A and B and a thin metal plate to be attached to the profiled beam via the adaptor clip;
- Figure 15:: the thin metal plate and the adaptor clips of Figure 14 in the assembled state where the adaptor clips are attached to the metal plate;

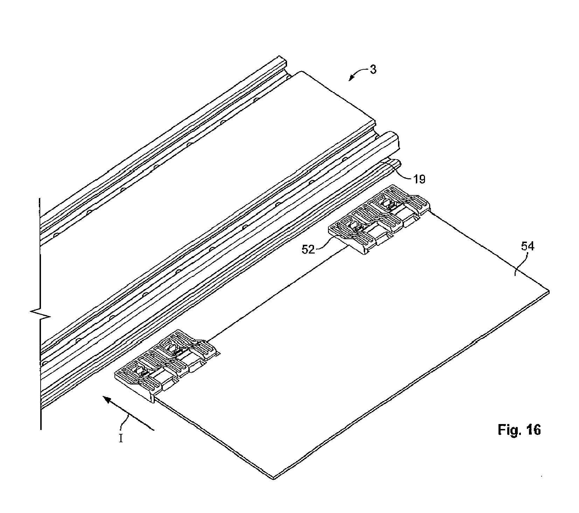

- Figure 16:: the assembly of the adaptor clips and the thin metal plats of Figure 15 and a profiled beam according to the present invention prior to assembly;

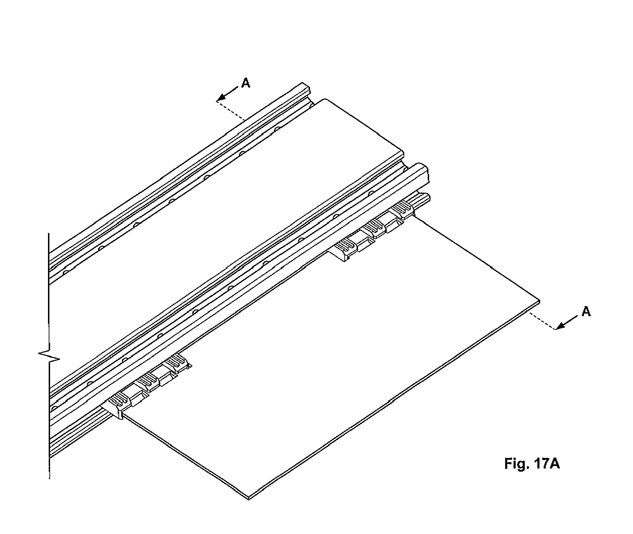

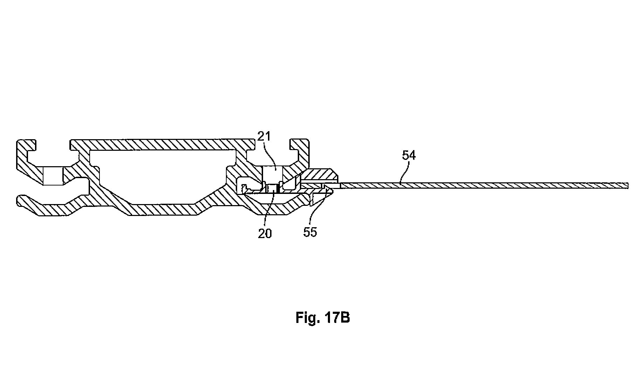

- Figure 17A, 17B:: the assembly of the adaptor clips and the thin metal plate of Figure 16 after insertion of the adaptor clips into the position groove of the profiled beam in a perspective schematic representation (Figure 17A) in a cross-sectional representation along the section line A-A (Figure 17B).

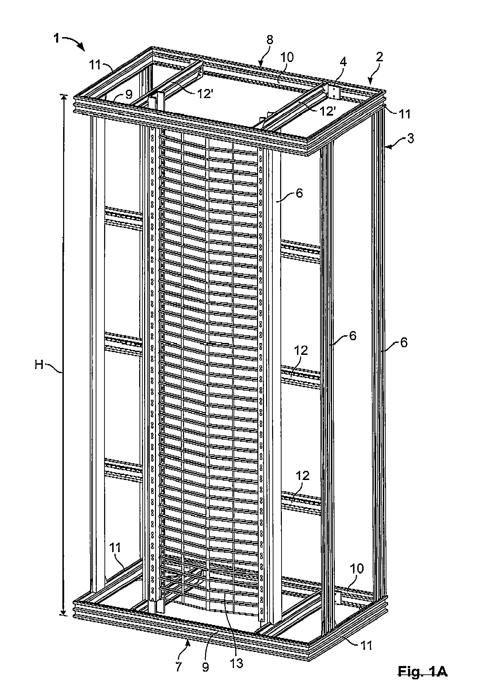

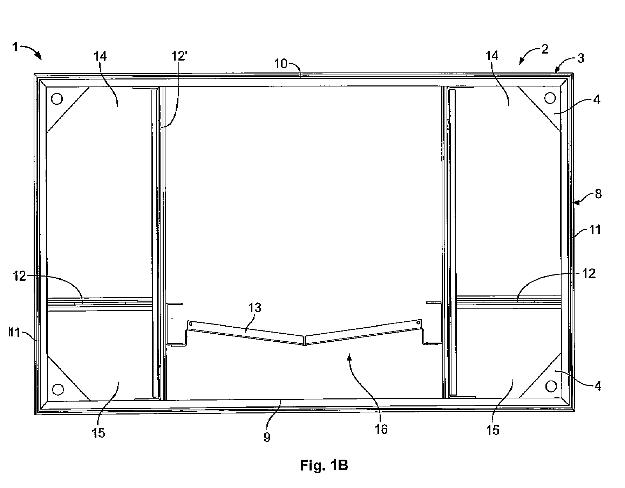

Figures 1A and 1B show a cable management cabinet 1 in a first embodiment. The cable management cabinet 1 comprises a frame 2 that is composed of profiled beams 3 that are connected with each other by joining elements 4. The joining elements 4 are affixed to the profiled beams 3 by means of fasteners 5.

Profiled beams 3 having a defined length constitute the longitudinal girders 6, that substantially determine the height H of the cable management cabinet 1. The longitudinal girders 6 connect the bottom rectangular 7 and the top rectangular 8 of the frame 2, each of which rectangular structures 7, 8 is composed of a front bar 9, a rear bar 10 as well as two side bars 11. Cross-beams 12 interconnect adjacent longitudinal girders 6 and other cross-beams 12' connect the front bar 9 and the rear bar 10 of the bottom rectangular 7 and the top rectangular 8. In each case, the cross-beams 12, 12' may be arranged perpendicular to the profiled beams they interconnect.

A patch panel 13 for housing cable connections may be attached in the middle, front part of the cabinet 1 between two longitudinal girders 6 that are connected to cross-beams 12'.

As can be seen in the top view of Figure 1B, the frame 2 of the cable management cabinet 1 divides the cable management system 1 into a cable management back side 14, a cable management front side 15 and a patching or patch panel area 16.

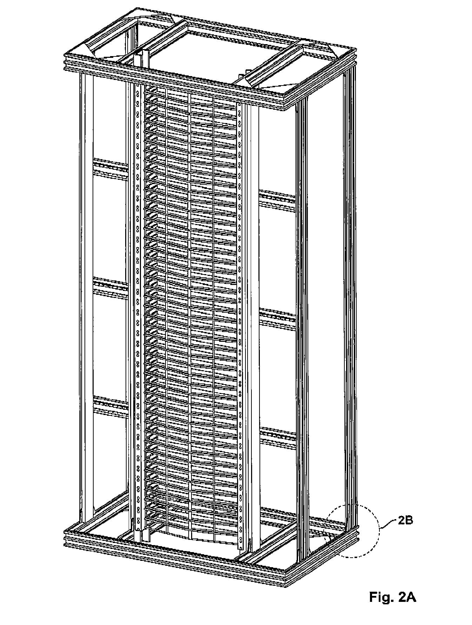

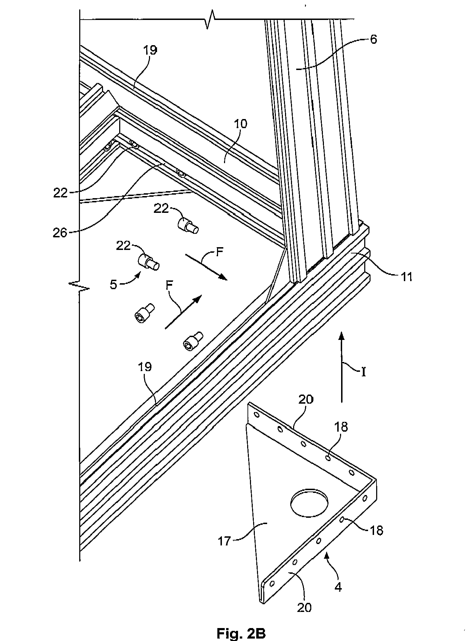

Figures 2A and 2B illustrate how two profiled beams 3, that meet each other at an angle of about 90° with their face side that are perpendicular to the longitudinal direction L of the beam 3, are connected with each other by means of a joining element 4 and fasteners 5. Connections, where profiled beams 3 are joined such, are, for example, the corners of the bottom rectangular 7 and corners of the top rectangular 8.

The joining element 4 of a corner connection may be composed of plate 17 in the form of a right-angled triangle. At the short side edges of the triangle, the joining element 4 comprises joining sections 18 that protrude as rails from the same side of the rectangular plate 17. Thereby, the rail or joining sections 18 form an elbow at their free longitudinal edge which is inserted along an insertion direction I into positioning grooves 19 of the profiled beams 3 that make up for the side bar 11 and the rear bar 10, as exemplarily shown in Figure 2B. Each of the rail-like joining sections 18 is provided with a series of through-holes 20. When the rectangular joining element 4 is placed at its connection position with the joining sections 18 in the position grooves 19, the through holes 20 are in alignment with fixation holes 21 formed in the bottom 39 of the positioning groove 19 of the profiled beam 3. For affixing the joining element 18 to the profiled beams 3, fasteners 5, in the present embodiment hexagonal socket head cap screws 22 are introduced along a fastening direction F into the fastening channel 26, through a fixation hole 21 and through the through-hole 20 of the joining element 4. Thereby, the joining element 4 is securely and easily affixed to the profiled beam 3 and connects the rear bar 10 with the side bar 11 at the corner of the cabinet 1.

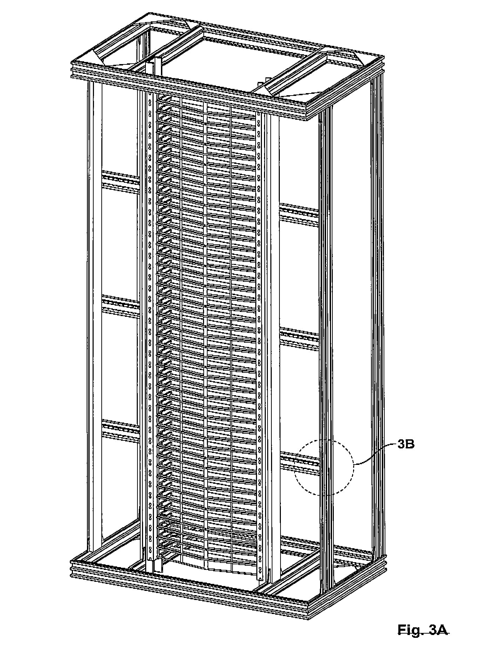

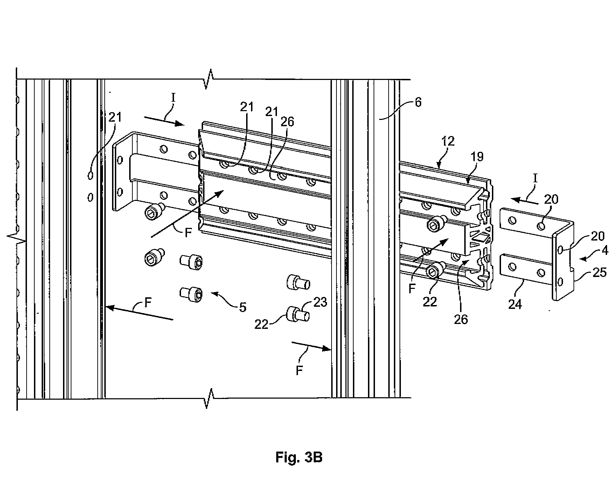

Figures 3A and 3B illustrate an exemplary embodiment of a joining element 4 for connecting a cross-beam 12 between adjacent longitudinal girders 6. The fixation principally corresponds to the fixation shown in Figure 2B by means of hexagonal socket head cap screws 22 as fasteners 5 for affixing the joining element 4 in the positioning groove 19 of the profiled beam 3.

The joining element 4 in the embodiment shown in Figure 3B comprises two parallel arms 24 made by long, narrow metal plates that are provided with through-holes 20. The two parallel arms 24 are interconnected to each other via a yoke section 25 giving the joining element 4 in the embodiment shown in Figure 3B a substantially U-shape, when looking onto the two arms 24, and a substantially L-shaped side appearance, when looking on the longitudinal edges of one arm 24 and of the yoke section 25. The yoke section 25 is, like the arms 24, formed as a flat-rod-shaped joining section 18 having through-holes 20 that extend substantially perpendicular to the ribbon-like arms 24 giving the joining element 4 an angular shape. Such joining element 24 may be manufactured from a U-shaped flat-rod with through-holes 20, whose yoke 25 is bended 90°

For interconnecting a cross-beam 12 with two adjacent longitudinal girders 6, at both longitudinal ends of the cross-beam 12, one joining element 4 is introduced such that each of the arms 24 is introduced into one positioning groove 19 of the cross-beam 12, which beam 3 comprises two parallel positioning grooves 19 at the top side 28. By introducing the fasteners 5 into the fastening channel 26 such that the thread 23 of the screw 22 extends through the fixation hole 21 forming an opening in the bottom 39 of the fastening channel 26 and through the through-hole 20 in the arms 24 of the joining element 4, one joining element is affixed at each longitudinal side of the cross-beam 12. For facilitating and guiding the introduction of the fastener 5, in particular in case the fastener is a screw 22, the through-hole 20 of the joining element 4 and/or fixation hole 21 may have a thread.

After the two joining elements 4 have been affixed to the cross-beam 12, the yoke sections 25 protrudes out of the top side 28 of the beam 12. Then, the yoke sections 25 can be introduced in corresponding positioning grooves 19 of the longitudinal girders 6 that are to be interconnected, by fasteners 5, in the exemplary embodiment, hexagonal socket head cap screws 22.

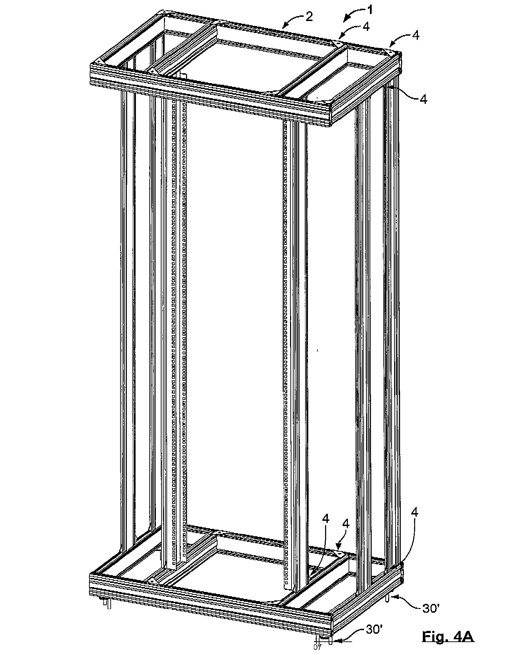

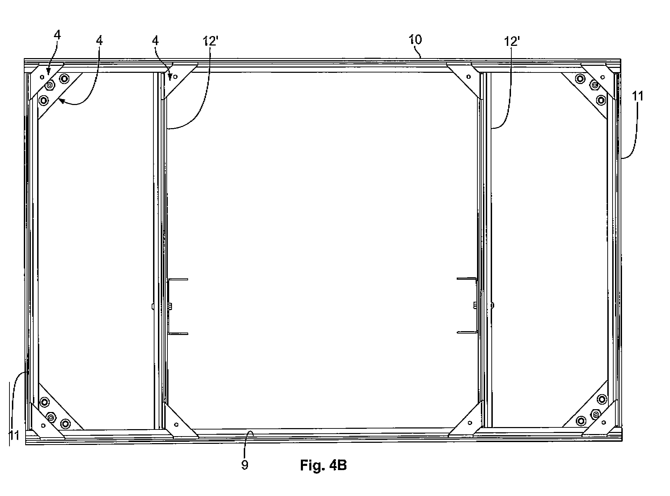

Figures 4-7 display a frame 2 of a cable management cabinet 1 of a second embodiment in the following the same reference signs will be assigned to elements corresponding to elements of the first embodiment and/or element having the same or a similar technical function.

The frame 2 of the embodiment shown in Figure 4A differs from the cable management cabinet 1 of Figure 1A in that the cross-beams 12 are omitted and in that joining elements 4 of different design are used.

Furthermore, the cable management cabinet 1 with the frame 2 of the embodiment shown in Figure 4A is provided with feet 30', the height of which can be adjusted for balancing the cable management cabinet 1, avoiding titling of the cable management cabinet 1 and thus ensuring a secure standing in the upright position.

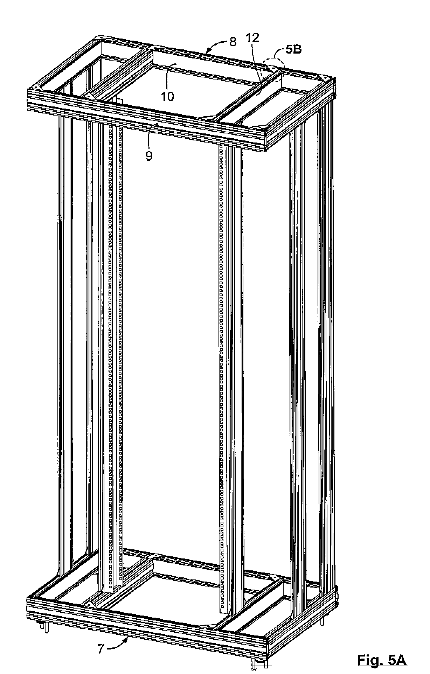

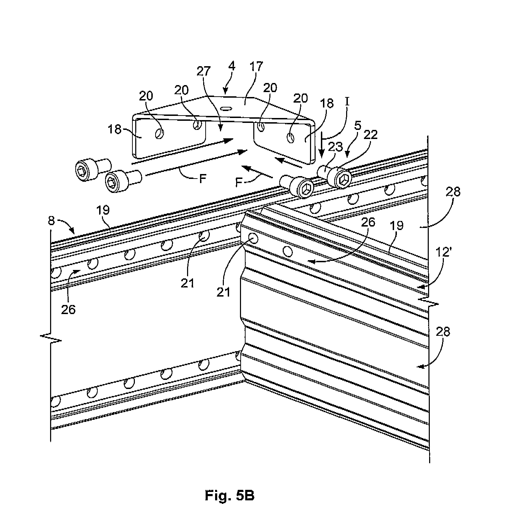

Figures 5A and 5B illustrate a further embodiment of a joining element 4, that is based on the joining element illustrated in Figure 2B and allows for, inter alia, connecting two profiled beams 3 placed with their longitudinal directions at about 90° to each other in a way head-to-head with their longitudinal ends, i.e. the side faces in the longitudinal direction D of the beams 3.

The joining element 4 of Figures 5A and 5B differs from the joining element 4 of Figure 2B in that the plate 17 is of trapezoid shape, because the part at the rectangular angle of the joining element 4 of the embodiment of Figure 2B is cut off. In one aspect, this allows for a more flexible structure that facilitates the insertion of the two joining sections 18 in the corresponding positioning grooves 19 of the profiled beams 3 to be connected. A further advantage is that, due to the trapezoid shape of the plates 17, the rail-like joining sections 18 do not meet each other and a gap or slot 27 is provided therebetween. Due to this slot 27, the joining element 4, as shown in Figure 5B, can not only be used to connect profiled beams 3 at the corner of a rectangular structure 7, 8 of the frame 2. The cross-beams 12' connecting the front bar 9 and the rear bar 10, that meet the front or top sides 28 of the front bar 9 and rear bar 10 with their longitudinal end faces, can likewise be connected with such a joining element 4.

In the fixed position, as shown in Figure 5A, each longitudinal side face of each cross-beam 12' rests at a top side 28, that is provided with a fastening channel 26 of the profile beam 3 to be connected therewith. Thus, the positioning grooves 19 of the front 9 and rear bar 10 do not directly meet and open into the positioning groove 19 of the cross-beam 12. Hence, the corner joining element 4 shown in Figure 2B could not be used The joining element 4 shown in Figure 5B, however, can be used for connecting a cross-beam 12' with the rear bar 9 and the front bar 10 because the slot 28 allows for bridging the gap between the positioning grooves 19 in the respective profiled beams 3 and therefore allows for a corner connection of profiled beams 3, even though their positioning grooves 19 do not directly meet or end at the connection position.

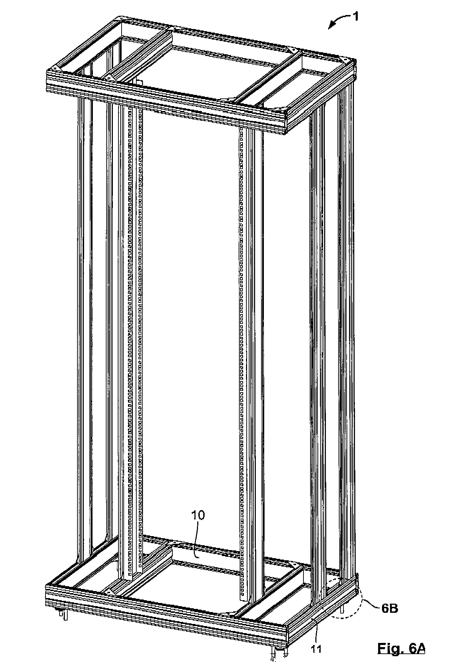

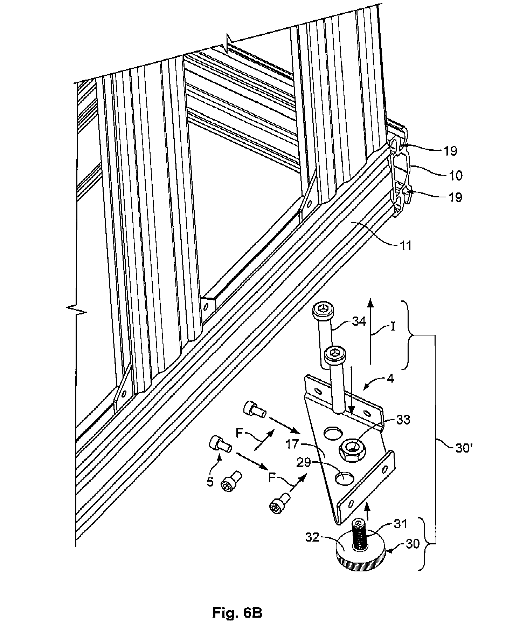

Figures 6A and 6B illustrate the bottom corner joining element 4 of the embodiment of the cable management cabinet 1 illustrated in Figures 4-7. The shape of the corner bottom joining element 4 principally corresponds to the shape of the corner joining elements 4 displayed in Figure 5B, with the exception that the bottom corner joining elements 4 of Figure 6B are larger, as can be seen in the top view in Figure 4A. The plate 17 of the joining element 4 for the bottom corners is provided with feet holes 29 for attaching feet elements 30' on which the cable management cabinet 1 is placed and secured in the upright position shown, e.g. in Figure 6A.

The feet element 30' may be in the form of a feet screw 30 having a thread 31 and a standing base 32, on which the cable management cabinet 1 is to be placed. By inserting the head 31 into one feet hole 29 that is designed with a nut 33 integrated in the plate 17, the feet screw 30 can be attached to the joining element 4 and the distance of the standing base 32 from the plate 17 can be adjusted by turning the feet screw 30. Additionally and/or alternatively to the feet screw 30, attachment bolts 34 can be used. Such attachment bolts 34 can be inserted through corresponding feet holes 29 in the direction from the top to the bottom and can be used for anchoring the cable management cabinet 1 on the ground.

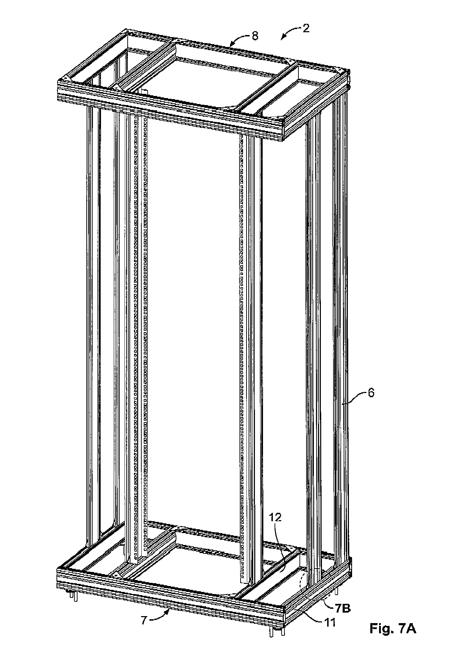

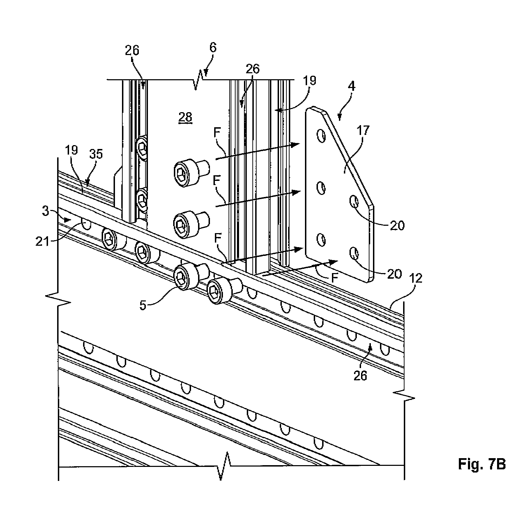

Figures 7A and 7B illustrate joining elements 4 in an embodiment that can be used for connecting the longitudinal girders 6 with the side bars 11 or cross-beams 12 of the bottom rectangular 7 and the top rectangular 8. The side face of the longitudinal girder 6 facing in the longitudinal direction L is placed at one lateral side 35 of another profiled beam 3, on which lateral side 35 the longitudinal groove 19 is provided. That is, the positioning groove 19 of the longitudinal girder 6 directly ends into the corresponding positioning groove 19 of the cross-beam 12 so that a joining element 4 in the simple form of a plate 17 having through-holes 20 along at least two sides, that are substantially perpendicular to each other, can be used for connecting a longitudinal girder 6 with a side bar 11 or a cross-beam 12 of the cable management cabinet 1.

In the following, an embodiment of a profiled beam 3 and the attachment of a cable management hardware or an accessory 36 thereto is disclosed.

The cable management hardware 36 is composed of a metal plate 36 having on one side 36a thereof a series of regularly spaced apart through-holes 20. This attachment side 36a of the cable management hardware 36 is inserted along an insertion direction I in the positioning groove 19 of the profiled beam 3. On the opposite side, the hardware side 36b, various coupling holes 37 are provided. The distance between adjacent coupling holes 37 is larger than the distance between regularly and narrowly spaced adjacent through-holes 20, and the diameter thereof is larger.

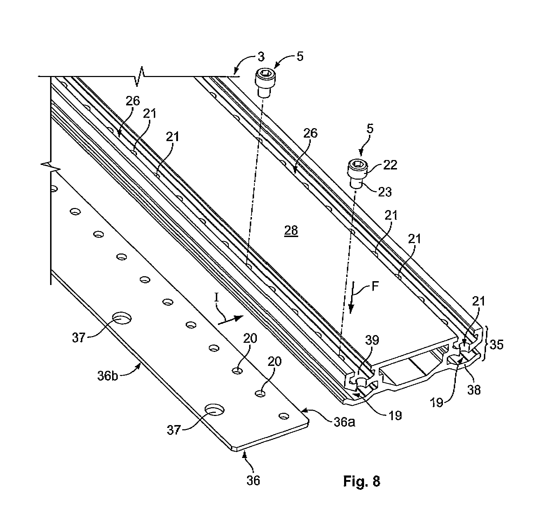

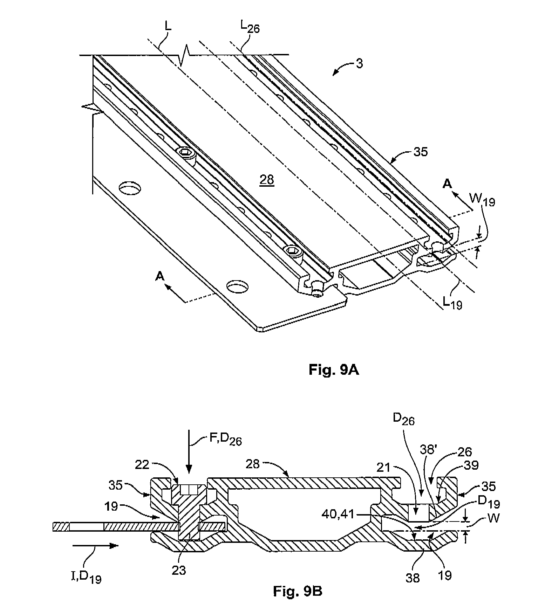

As fastener 5 in the embodiment shown in Figures 8 and 9, a hexagonal socket head cap screw 22, that has already been described in detail in the previous figures, is used for affixing the cable management hardware 36 with its attachment side 36a in the positioning groove 19 to the profiled beam 3.

The profiled beam 3 may comprise two positioning groove 19 and two fastening channel 26, wherein fixation holes 21 form an opening from the fastening channel 26 to the positioning groove 19 such that facing a side wall 38 of the positioning groove 19. The profiled beam 3 is substantially bar shaped and may have a substantially rectangular cross-section. The embodiment shown in Figures 8-9 comprises a profiled beam 3, wherein the longitudinal axis L19 of the positioning grooves 19 and the longitudinal axis L26 of the fastening channel 26 both run substantially parallel to the longitudinal direction L of the profiled beam.

Alternatively, the lateral sides 35 of the beam 3 may be slanted providing the beam 3 a substantially trapezoid cross-section. This embodiment may be particularly suited for making a corner connection, e.g. where a rear bar 10 and a side bar 11 meet.

In the shown embodiment, the profiled beam 3 is provided with two positioning grooves 19 that are arranged on the opposite, lateral sides 35 of the profiled beam. The profiled beam 3 comprises two fastening channels 26 that are both arranged on the top side 28 of the profiled beam. One of said fastening channels 26 is assigned to one of the positioning grooves 19 at each lateral side 35 of the profiled beam 3. That is, the profiled beam 3 is symmetrically designed with respect to the plane of symmetry in the middle of the profiled-bar 3 running along the longitudinal direction L of the beam 3.

At the bottom 39 of each fastening channel 26 a series of fixations holes 21 are formed along the longitudinal axis L26 of the fastening channel 26. The fixation holes 21 are uniformly spaced apart from each other allowing for a nearly arbitrary fixation of the cable management hardware 33 along the longitudinal axis L19 in the positioning groove 19.

The depth direction D26 of the fastening channel 26 is substantially perpendicular to the depth direction D19 of the corresponding positioning groove 19. Principally, the depth direction D19 of the positioning groove 19 corresponds to the insertion direction I of placing a joining element 4 or the cable management hardware 36 into the positioning groove 19. The depth direction D26 of the fastening channel 26 principally corresponds to the fastening direction F of placing the fastener in the fastening channels 26 such that extending through the fixation hole 21 and the through hole 20.

A locking recess 40 is formed in the side wall 38 of the positioning groove 19 that is opposite to the other side wall 38' that likewise forms the bottom 39 of the fastening channel 26 and is provided with the fixation holes 21. The locking recess 40 may be designed as a locking groove 41 that substantially runs parallel to the longitudinal axis L26 of the fastening channel 26 and is in alignment with all fixation holes 21 of the fastening channel 26. By providing the sidewall 38 of the positioning groove 19 with a locking groove 41, the thread 23 of the fasteners 5, that serves as fixation bolt, can be secured in the profiled beam 3 on both sides of the joining plate 17 or the cable management hardware 36. On one side, the thread 23 is secured in the fixation hole 21, on the other, the thread 23 is secured in the locking groove 41.

When the fastener 5 is in the fixation position, shown on the left side in Figure 9, the fastener 5 extends through the fixation hole 21 and the through-hole 20 and thus affixes the joining element 4 or the cable management hardware 36 in the positioning groove 19 to the profiled beam 3 such that it cannot be moved in or against the depth direction D19 of the positioning groove or along the longitudinal axis L19 of the positioning groove 19 by extending through the through-hole 20.

The side walls 38, 38' of the positioning groove 19 have in an inner width W that principally corresponds to the thickness of the plates 17 of the joining element 4 or the cable management hardware 36, thereby securing said elements in the positioning groove in the direction perpendicular to the depth direction D19 and to the longitudinal L19.

In one embodiment of the positioning groove 19, one sidewall 38 thereof may be pulvinated and the other sidewall thereof 38' may be dished. In such a design, the positioning groove obtains a curved shape the depth direction D19, if viewed onto the cross-section 19 of Figure 9B. With such a curved design of the positioning groove 19, the actual width W19 of the positioning groove 19 may be wider than the inner width thereof, viewed onto the lateral side 35 of the profiled beam 3 in the depth direction D19. The curved structure with a pulvinated sidewall 38 and a dished sidewall 38' allows for a three-point support of the attachment side 36a of a cable management hardware 36 or a joining element 4. One support point is at the entrance of the positioning groove 19 on the sidewall 38, the second support point is near the bottom at the sidewall 38 and the third support point is around the fixation hole 21 at the dished sidewall 38'. The three-point support avoids tilting of joining element 4 or a cable management hardware 36 that is completely inserted into the positioning groove 19, as shown, e.g. on the left side in Figure 9B. Moreover, the curved structure of the positioning groove 19 provides an indication that the cable management hardware 36 or joining element 4 is inserted along the insertion direction I completely up to the bottom of the positioning groove 19 because only in that position, the cable management hardware 36 or the joining sections 18 of joining element 4 is substantially parallel to the profiled beam 3. Otherwise, i.e. if not completely inserted, the cable management hardware 36 would be angled with respect to the top side 28 of the profiled beam 3.

Moreover, the curved positioning groove 19 having a pulvinated sidewall 38 and a dished sidewall 28', that may, e.g., be composed of three linear sections that are angled with respect to each other, provide the positioning groove with kind of a resilience improving the insertion and support of the element to be attached therein.

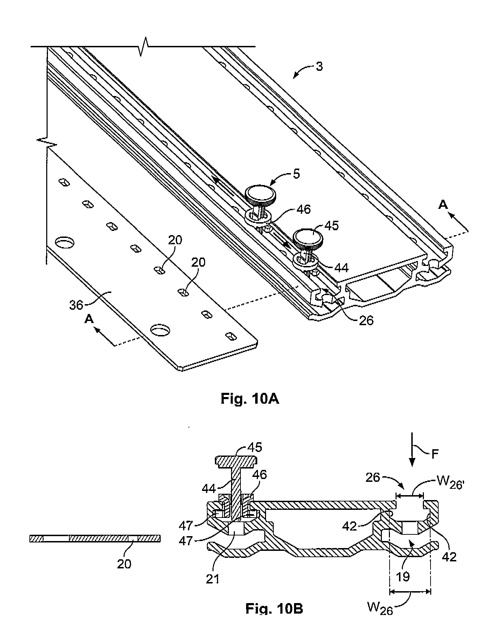

Figures 10-12 show a further embodiment of the fastener 5 for affixing a metal hardware 36 in the positioning groove 19 of a profiled beam 3. The profiled beam 3 shown in Figures 10-12 is identical to the profiled beam shown in previous Figures 8 and 9.

The cable management hardware 36 of Figure 10-12 principally corresponds to the cable management hardware 36 of Figures 8 and 9, with the exception that the through-holes 20 are adapted to the embodiment of the fastener 5 and have a substantially rectangular circumference, rather than a circular circumference as the embodiment shown in Figures 8 and 9.

The fastener 5 of this embodiment may be designed to be slideably mounted along the longitudinal axis L26 of the fastening channel 26. The fastening channel 26 is an undercut channel in the shape of the T-slot channel. Due to this T-slot channel configuration, the width of the channel W26 is wider than the width W26' at the insertion opening of the fastening channel 26. Thereby two lateral guiding grooves 42 are formed to allow for guiding the fastener 5 in the fastening channel 26, and catches 43 are also formed at the channel entrance securing the fastener 5 in the fastening channel 26 against being pulled out of the fastening channel 26 against the fastening direction F. The fastener 5 of this embodiment comprises a fastening pin 44 having an activation head 45 on one end thereof, that is opposite to the end inserted into the positioning groove 19. This fastener 5 with the activation head 45 and the fastening pin 44 may be moved relative to the longitudinal axis L26 in the fastening channel 26 for inserting the fastening pin 44 through the fixation hole 21 and the through-hole 20.

The fastener 5 further comprises an attachment part 46, whereby the fastening pin 44 is mounted slideable relative to the attachment part 46.

The attachment part 46 comprises, at the end facing away from the activation head 45 of the fastener 5, two wings 47 on opposing sides that extend laterally with respect to the pin 44 mounted in the attachment part 46. When orientating the wings 47 in the direction of the longitudinal axis L26 of the fastening channel 26, the wings 47 of the attachment part 46 can be placed in the fastening channel 26, because the width of the wings 47 is smaller than the width W26' at the insertion opening of the fastening channel 26.

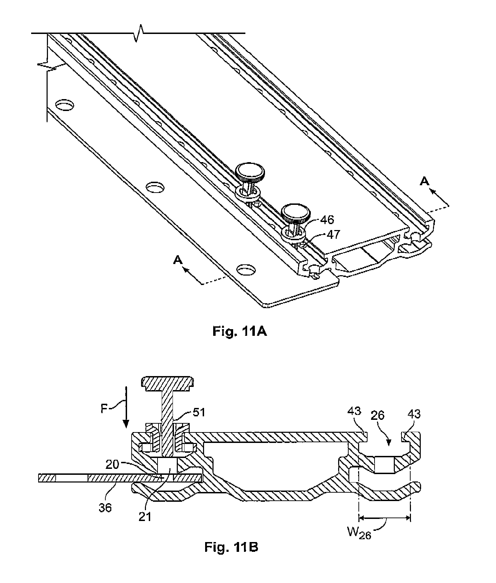

After inserting the wings 47 of the attachment part 46 in the fastening channel 26, the fastener is turned 90°, thereby positioning the wings 47 in the guiding grooves 42 of the fastening channel 26. In this pre-mounted position the fastener 5, that is shown in Figure 10 and 11, the wings 47 and the guiding grooves 42 form a guiding 42, 47 for moving the fastener 5 along the longitudinal axis L26 in the fastening channel 26. At the same time the wings 47 abut against the catches 43 and thus secure the fastener 5 against being pulled out of the fastening channel 26 against the fastening direction F.

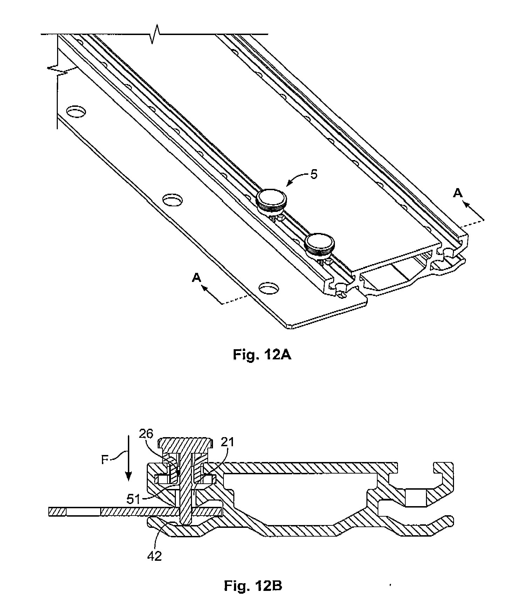

The fastening pin 44 is provided with notches 48 extending laterally out of the fastening pin 44. In the pre-mounted position of Figures 10 and 11, where the fastener 5 is slideably mounted in the fastening channel 26, the notches 51 rest, in the fastening direction F before the attachment part 46. After moving the fastening pin 44 in the fixation direction F by pushing on the activation head 45, the fastening pin 44 is inserted through the fixation hole 21 and the through-hole 20 of the joining element 4 or the cable management hardware 36 to be secured. In this final mounting position, shown in Figure 12, the fastening pin 44 extends from the fastening channel 26 through the fixation hole 21, through the through-hole 20 into the locking groove 41 of the positioning groove 19. In this end position, the notches 51 rest, in the fastening direction F behind the attachment part 46. Thus, for lifting the back into the pre-mounted position shown in position 10 and 11, a certain release force is required to move the notches 48 out of abutment with the attachment part 46.

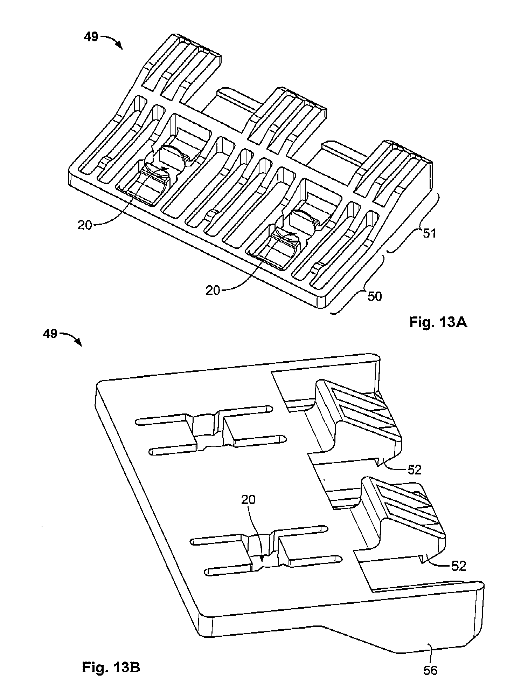

Figures 13A and 13B show an adaptor clip 49 that can be used for attaching a thin metal plate 54 having a width substantially smaller than the width W of the positioning groove 19 in the positioning groove 19. The adaptor clip 49 can likewise be used for a fast and easy attachment of other elements, like joining element 4, cable management hardware and/ore accessories instead of thin metal plate 54.

The adaptor clip 49 has an attachment section 50 on one side and a clipping section 51 on the opposite side. The attachment section 50 is substantially rectangular and comprises through holes 20. This attachment section 50 can be placed in the positioning groove 19, similar to a joining element 4 or a cable management hardware 36 having through holes 20. The through-hole 20 of the adaptor clip 49, like the through-holes 20 of any joining element 4, cable management hardware and/or accessories to be connected with the profiled beam 3, may have a thread.

The clipping section 51 comprises catches 52 that can be connected with corresponding clipping holes 53 provided in a thin metal plate 54 to be attached to the profiled beam 3 via the adaptor clip 49.

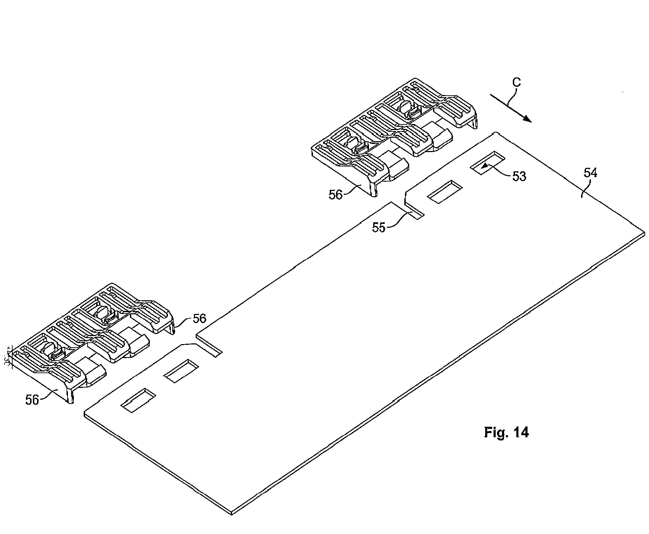

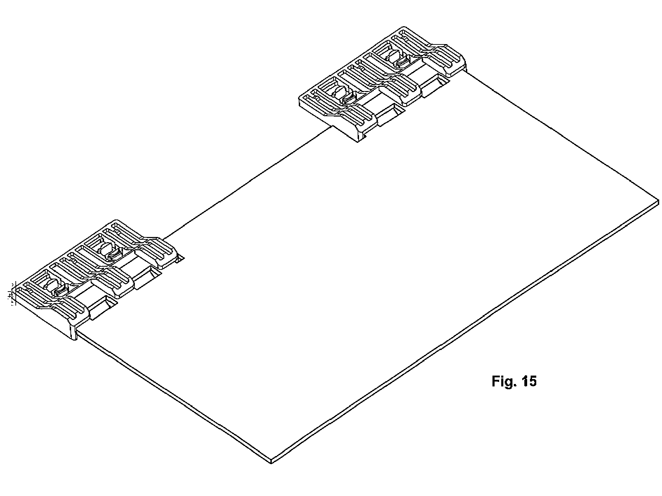

As can be seen in Figure 14 and 15, the adaptor clip 49 is attached to the metal plate 54 by pushing the adaptor clip 49 in a pushing direction C onto the edge of the metal plate 54 that is provided with the clipping holes 53 such that the catches 52 come to rest in the clipping holes 53. In this position, the adaptor clip 49 is secured to the metal plate 54.

The correct attachment of the adaptor clip 49 and guiding in the clipping direction C may be assured by providing the adaptor clip 49 with a guiding rib 55 that is introduced into a guiding slit 56 provided in the thin metal plate. Thereby, attachment of the adaptor clip 52 is only possible if the guiding rib 55 of the adaptor clip 49 is inserted into the guiding slip 56 of the metal plate 54.

After the adaptor clip 49 is connected with the thin metal plate 54, the attachment section 50 of the adaptor clip 49 can be inserted along the insertion direction I into the positioning groove 19 of a profiled beam 3 and can be placed in the positioning groove 19 such that the through-hole 20 of the attachment section 50 comes into alignment with the fixation holes 21 in the fastening channel 26 so the fastener can be inserted extending through the fixation hole 21 and the through-hole 24 attaching the adaptor clip 49 to the profiled beam 3.

## Claims

1. A profiled beam (3) for building a cable management cabinet (1), comprising at least one positioning groove (19), at least one fastening channel (26), and at least one fixation hole (21) forming an opening from the fastening channel (26) to the positioning groove (19) and facing a sidewall (38) of the positioning groove (19).

2. The profiled beam (3) of claim 1, **characterized in that** at least one of the positioning groove (19) and the fastening channel (26) runs substantially along the longitudinal direction (L) of the beam (3).

3. The profiled beam (3) of claim 1 or 2, **characterized in that** a series of fixation holes (21) are formed along the fastening channel (26), wherein the fixation holes (21) are preferably uniformly spaced apart from each.

4. The profiled beam (3) of any one of claims 1 to 3, **characterized in that** a depth direction (D₂₆) of the fastening channel (26) and a depth direction (D₁₉) of the positioning groove (19) are substantially perpendicular.

5. The profiled beam (3) of any one of claims 1 to 4, **characterized by** at least one locking recess (40) that is formed in the sidewall (38) and that is in alignment with a corresponding fixation hole (21).

6. The profiled beam (3) of claim 5, **characterized in that** the locking recess (40) is a locking groove (41) that runs substantially parallel to the fastening channel (26), or a blind hole.

7. The profiled beam (3) of any one of claims 1 to 6, **characterized in that** the sidewall (38) of the positioning groove (19) is pulvinated and the other sidewall (38') is dished.

8. The profiled beam (3) of any one of claims 1 to 7, **characterized in that** the fastening channel (26) is an undercut channel.

9. The profiled beam (3) of claim 8, **characterized in that** the fastening channel (26) is T-slot channel.

10. The profiled beam (3) of any one of claims 1 to 9, **characterized in that** the profiled beam is an extrusion profile.

11. The profiled beam (3) of any one of claims 1 to 10, **characterized by** two positioning grooves (19) that are preferably arranged at opposite sides (35) of the profiled beam (3).

12. The profiled beam (3) of claim 11, **characterized by** two fastening channels (26) that are arranged at the same side (28) of the profiled beam (3).

13. The profiled beam (3) of any one of claims 1 to 12, **characterized in that** the profiled beam (3) is symmetrically designed with respect to a plane of symmetry running along the longitudinal direction (L) of the beam (3).

14. An assembly kit (61) for building a cable management cabinet (1), comprising:
a profiled beam (3) according to any one of claims 1 to 13,
a joining element (4) comprising at least two through-holes (21), and
a fastener (5) for affixing the joining element (4) to the profiled beam (3), when being positioned extending through a fixation hole (21) of the beam (3) and a through-hole (20) of the joining element (4).

15. A cable management cabinet (1) comprising profiled beams (3) according to any one of claims 1 to 13, joining elements (4) comprising at least two through-holes (20) that connect profiled beams (3), and fasteners (5) that affix the joining elements (4) to the profiled beams (3) in the positioning grooves (19) by extending through a fixation hole (21) of a beam (3) and a through-hole (20) of a joining element (4).
